# EUROPEAN PATENT APPLICATION

(11) **EP 4 718 456 A1**
(43) Date of publication of application: **01.04.2026**
(21) Application number: 25197107.3
(22) Date of filing: 20.08.2025
(51) Int. Cl.: G11C 11/419, G11C 7/12, G11C 7/18, G11C 5/06, H10B 10/00

(54) **HIGH PERFORMANCE STATIC RANDOM-ACCESS MEMORY**

(30) Priority: 27.09.2024 US 202418900259
(71) Applicant: Intel Corporation, Santa Clara, CA 95054 (US)
(72) Inventor: AUGUSTINE, Charles, Portland 97229 (US); GHOSH, Amlan, Portland 97229 (US); MERCHANT, Feroze, Austin 78750 (US)
(74) Representative: HGF

(57) **Abstract**

Embodiments herein relate to Static Random-Access Memory (SRAM) where a column of cells includes first and second sets of bit lines. First and second pre-charge circuits are also provided to allow independent precharging of the sets of bit lines such as for write or read operations. For a read operation, a sense circuit for the column is coupled to one of the sets of bit lines by a multiplexer. The SRAM can be implemented using complementary field-effect transistor (CFET) technology, where n-type and p-type transistors are arranged in a stacked configuration on top and bottom levels, respectively of a stack. Additionally, the first and second sets of bit lines can be provided in top and bottom metal layers, respectively, of the stack. In another option, a third set of bit lines is provided using an intermediate metal layer.

## Description

### BACKGROUND

The demand for memory in computing devices has increased, e.g., as larger on-die caches are employed such as in high-performance processors. Static Random-Access Memory (SRAM) is a candidate for supporting these workloads and providing on-chip high density memory. However, various challenges are encountered in meeting performance and scalability goals.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.
FIG. 1 depicts a cross-sectional view of an example complementary field-effect transistor (CFET) device 100, including an n-type transistor layer 130 above a p-type transistor layer 120, according to various embodiments.
FIG. 2 depicts an example SRAM device 200 including a set of memory cells 210 arranged in rows and in columns, where the columns include two or more sets of bits lines, according to various embodiments.
FIG. 3 depicts a circuit diagram of an example six-transistor (6T) Static Random-Access Memory (SRAM) cell 300, consistent with any of the memory cells of FIG. 2, according to various embodiments.
FIG. 4 depicts an example layout of the n-type transistor layer 130 of FIG. 1, consistent with the memory cell 300 of FIG. 3, according to various embodiments.
FIG. 5 depicts an example layout of the p-type transistor layer 130 of FIG. 1, consistent with the layout of the n-type transistor layer of FIG. 4, according to various embodiments.
FIG. 6 depicts an example layout of front and back side metal layers M0 and BM0, respectively, consistent with FIGs. 4 and 5, where the bit lines are in M0 portions, according to various embodiments.
FIG. 7 depicts another example layout of front side and back side metal layers M0 and BM0, respectively, consistent with FIGs. 4 and 5, where the bit lines are in BM0 portions, according to various embodiments.
FIG. 8A depicts an example column of memory cells 800 which has first and second sets of bit lines 801 and 802, respectively, and associated first and second pre-charge circuits 821 and 822, respectively, according to various embodiments.
FIG. 8B depicts an example timeline for a read or write operation in the column of FIG. 8A, according to various embodiments.
FIG. 8C depicts another example timeline for a read or write operation in the column of FIG. 8A, according to various embodiments.
FIG. 9 depicts an example layout of front and back side metal layers M0 and BM0, respectively, consistent with FIG. 8, where the first and second sets of bit lines 801 and 802 are in M0 and BM0 portions, respectively, according to various embodiments.
FIG. 10A depicts a layout of control gate and source/drain paths of an n-type transistor layer consistent with FIG. 4, according to various embodiments.
FIG. 10B depicts a layout of control gate and source/drain paths of a p-type transistor layer consistent with FIG. 5, according to various embodiments.
FIG. 11 depicts an example perspective view of different metal layers and vias in an SRAM device, consistent with FIGs. 8-10B, in accordance with various embodiments.
FIG. 12A depicts an example column of memory cells which has first, second and third sets of bit lines 1201, 1202 and 1203, respectively, and associated first, second and third pre-charge circuits 1223, 1222 and 1221, respectively, according to various embodiments.
FIG. 12B depicts an example timeline for a read or write operation in the column of FIG. 12A, according to various embodiments.
FIG. 13 depicts an example layout of front, back and intermediate metal layers consistent with FIG. 12A, where the bit lines BL(M0), BL(BM0) and BL(IM0) are in M0, BM0 and IM0 metal layer portions, respectively, according to various embodiments.
FIG. 14 depicts an example perspective view of different metal layers and vias in an SRAM device, consistent with FIGs. 10A-13, in accordance with various embodiments.
FIG. 15 illustrates an example of components that may be present in a computing system 1550 for implementing the techniques (e.g., operations, processes, methods, and methodologies) described herein.

### DETAILED DESCRIPTION

As mentioned at the outset, various challenges are encountered in meeting performance and scalability goals in memory devices.

For example, on-chip cache memories are integral part of many computing systems. Both memory capacity and bandwidth need to be scaled to meet the demands of existing and emerging workloads. While there is a clear path for logic scaling, memory devices are challenged in terms of capacity and bandwidth metrics. Complementary field-effect transistor (CFET) technology can potentially offer a solution to memory scaling by providing vertical stacking of p-type and n-type metal-oxide-semiconductor field-effect transistors (pMOSFETs and nMOSFETs, respectively). For example, CFET optimized designs can be provided for a six-transistor (6T) or 8T SRAM cell. However, continual improvements are desired.

The solutions provided herein address the above and other issues. In one aspect, the solutions provide performance improvements for a CFET SRAM device by incorporating two or more sets of bit-cells in the same array, to provide a hybrid memory device. For example, due to the 3D nature of the CFET technology, it is possible to design two sets of bit-cells (memory cells), one with a first set of bit lines formed in a top metal layer (e.g., M0) and another with a second set of bit lines formed in the bottom metal layer (e.g., BM0). A first subset of the cells in a column is coupled to the first set of bit lines, and a second subset of the cells in the column is coupled to the second set of bit lines.

In one approach, the M0 bit lines have a lower capacitance and higher resistance while the BM0 bit lines have a higher capacitance and a lower resistance. The capacitance of M0 is lower than BM0 due to a thinner metal in M0, and the resistance of M0 is higher than in BM0 due to a longer length of M0. With optimized placement of both types of cells in a column, a net reduction in the bit line capacitance can be achieved. Moreover, with the incorporation of independent pre-charge logic for both types of bit lines, higher performance for both read and write operations can be achieved. Also, different operations can be performed on the different subsets of memory cells, including pre-charge, read and write.

In another aspect, the cells in a column are divided into three groups which are coupled to three respective sets of bit lines. For example, first, second and third sets of bit lines can be formed in the top metal layer M0, an intermediate metal layer IM0 and the bottom metal layer BM0. IM0 can be provided between the n-type and p-type transistor layers.

Additionally, independent pre-charge circuits can be provided for each set of bit lines to allow pre-charging at different times and even to allow reading on one set of bit lines during writing on another set of bit lines. A multiplexer can select one set of bit lines to route to a sense amplifier in a read operation. The solutions are applicable to other types of memory cells as well including read-only memory (ROM) and all single- and multi-ported register file arrays, as well as dynamic random-access memory (DRAM) arrays.

The solutions provide a number of advantages including achieving higher performance for both read and write operations. Additionally, a pseudo-double pump array can be constructed. This refers to a memory design technique used in SRAM or DRAM to improve the effective data throughput without doubling the clock speed of the memory array itself. This is achieved by creating two pseudo clocks, which are phase-shifted versions of the original clock signal.

These and other features will be further apparent in view of the following discussion.

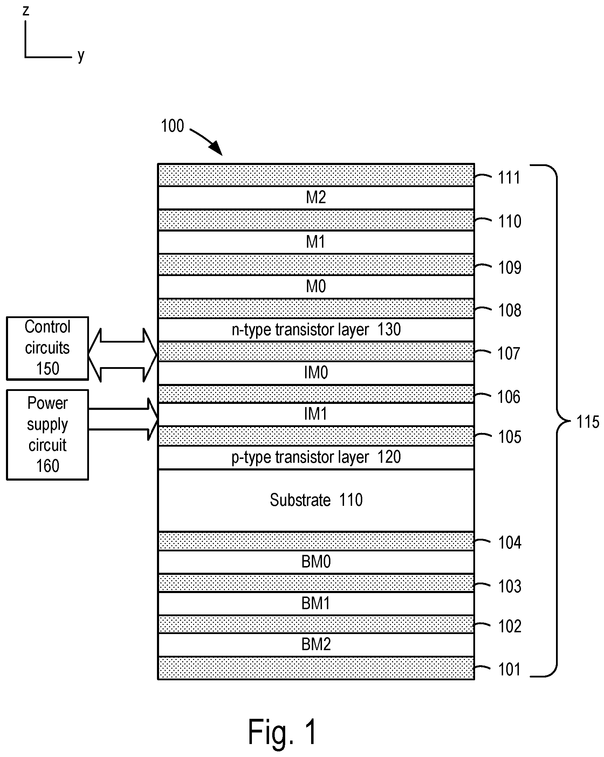

FIG. 1 depicts a cross-sectional view of an example complementary field-effect transistor (CFET) device 100, including an n-type transistor layer 130 above a p-type transistor layer 120, according to various embodiments. In an example implementation, the n-type transistor layer comprises nMOSFETs and the p-type transistor layer comprises pMOSFETs.

The device comprises a stack 115 of layers (a stacked semiconductor structure) which include a substrate 110, a p-type transistor layer 120 formed on the substrate and the n-type transistor layer 130 formed above the p-type transistor layer. The p-type transistor layer (a p-channel active layer) can include an n-type substrate with p-doped regions, and the n-type transistor layer (an n-channel active layer) can include a p-type substrate with n-doped regions. Additionally, example bottom metal layers BM0-BM2 and top metal layers M0-M2 can be provided below the substrate and above the n-type transistor layer 130, respectively. Intermediate metal layers IM0 and IM1 can also be provided. Dielectric layers 101-111 provide insulation between the metal layers and active layers and at the top and bottom of the stack.

An SRAM memory cell can be formed from a number of transistors using the CFET technology, where the nMOS transistors of the cell are in the n-type transistor layer 130 and the pMOS transistors are in the a p-type transistor layer 120.

Control circuits 150 can be provided which provide control signals to transistors in the p-type transistor layer 120 and n-type transistor layer 130, such as for read and write operations. The control circuits can include one or more voltage generators, for example, including word line and bit line voltage generators. A control circuit can perform at least one of a write or read operation in a memory array formed by the transistors in the n-type and p-type transistor layers. Additionally, a power supply circuit 160 can provide a power supply voltage Vcc. The power supply circuit can include one or more voltage generators, for example, for providing different voltage supplies.

In this example, the n-type transistor layer is above the p-type transistor layer but the reverse case is possible as well. Moreover, more than two transistor layers could be used in the stack.

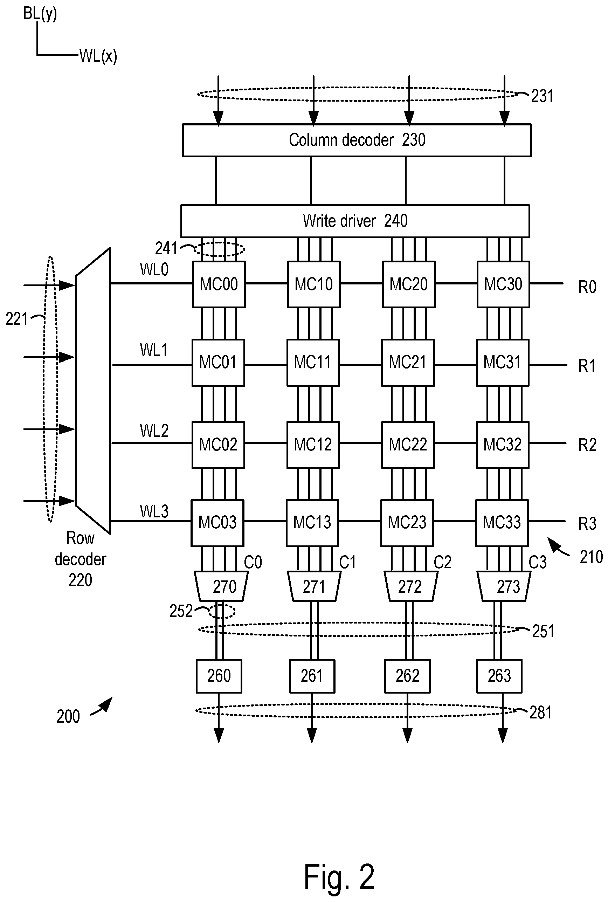

FIG. 2 depicts an example SRAM device 200 including a set of memory cells 210 arranged in rows and in columns, where the columns include two or more sets of bits lines, according to various embodiments. The set of memory cells (an array or grid of cells) includes four rows R1-R3 and four columns C0-C3, in a simplified example. C0 includes an example set of bit lines 241 which includes four bit lines or two bit line pairs. In R0, memory cells MC00, MC10, MC20 and MC30 are coupled to a word line WL0. In R1, memory cells MC01, MC11, MC21 and MC31 are coupled to WL1. In R2, memory cells MC02, MC12, MC22 and MC32 are coupled to WL2. In R3, memory cells MC03, MC13, MC23 and MC33 are coupled to WL3. A coordinate system depicts a word line direction WL(x), also referred to as a row direction, and a bit line direction BL(y), also referred to as a column direction.

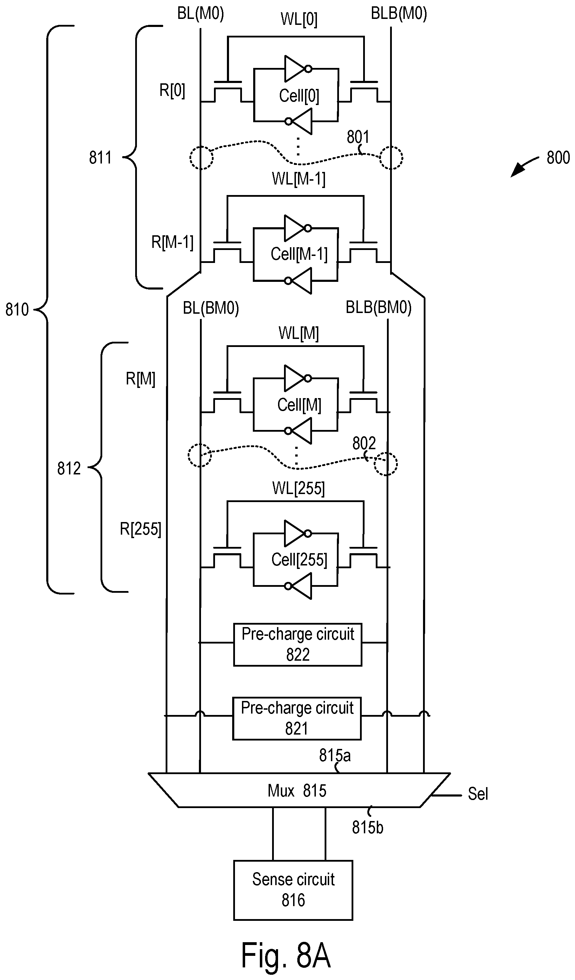

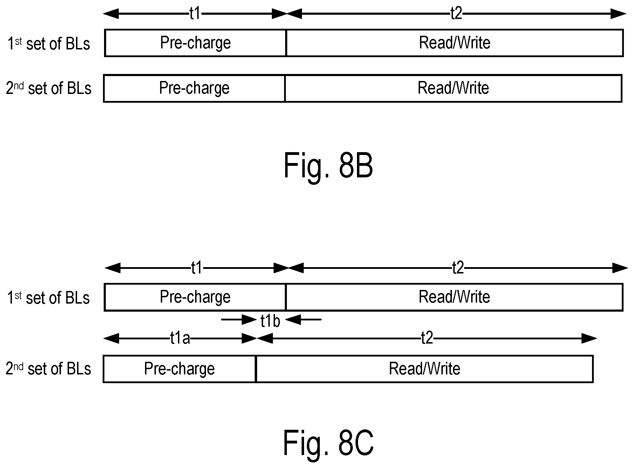

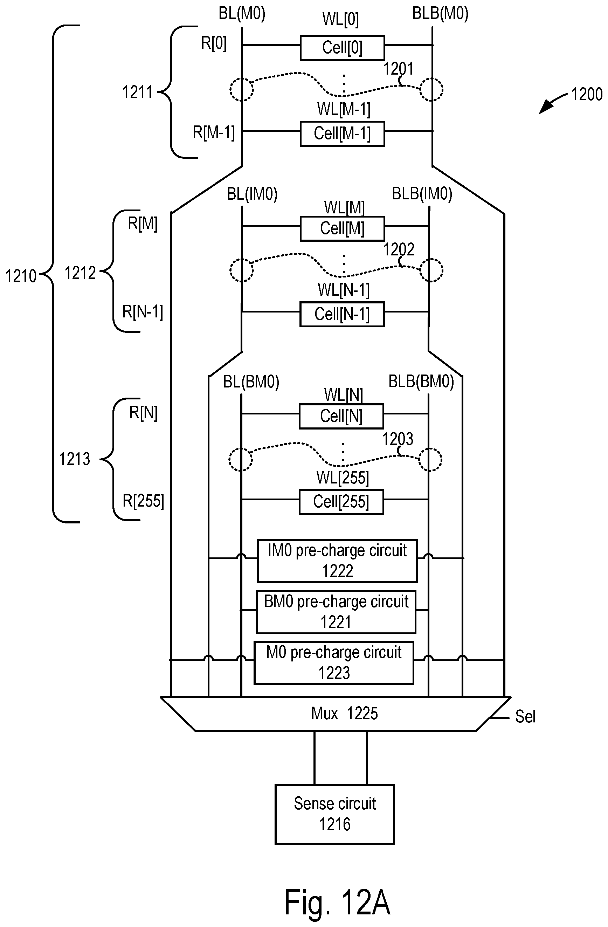

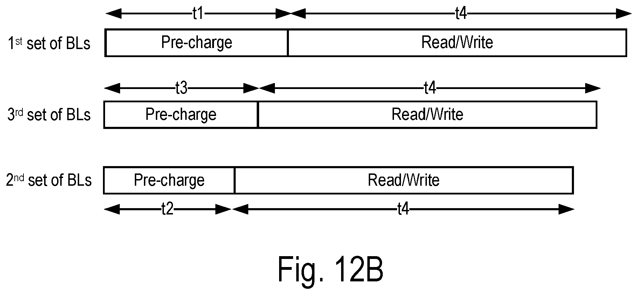

A row decoder 220 is coupled on an output side to the word lines and on an input side to row address lines 221, in response to which the row decoder selects one of the rows for a read or write operation. At the top of the array, a column decoder 230 is coupled on an output side to a write driver 240 and on the input side to column address lines 231, in response to which the column decoder selects one or more of the columns for a read or write operation. The write driver is coupled to the bit lines of the columns to provide voltages to the bit lines during read and write operations. A pre-charge circuit (see FIGs. 8 and 12) can be provide for each column to pre-charge voltages of the bit lines in preparation for read and write operations.

In this example, four bit lines are associated with each column. Each set of bit lines includes a primary bit line (BL) and a complementary bit line (BLB). Generally, each column may be associated with two or more sets (pairs) of bit lines.

At a bottom of the array, multiplexers (mux) 270, 271, 272 and 273 are coupled to a set of output lines 251, which may include one output line for each pair of bit lines in a column. In this example, there are two output lines per column, such as an example pair of output lines 252 for C0, based on the columns having two pairs of bit lines. The multiplexer selects one pair of bit lines for each column based on a respective select signal for output to a respective sense amplifier 260, 261, 262 or 263. In one approach, there is one sense amplifier for each column of cells.

In a write operation, the write driver 240 is responsible for writing a specific value into a selected memory cell. The write driver receives a signal from the column decoder 230 representing a bit value to be written and a write enable signal which enables or disables access to the bit lines by the write driver for each column.

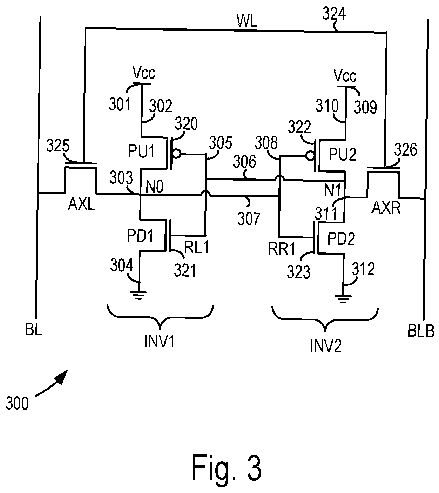

When access to a column is enabled, the write driver 240 charges or discharges the bit lines to a level corresponding to the bit to be written. One bit line is driven high and the other is driven low, in a pair of bit lines. Once the bit line voltages are set, an associated word line voltage is set to couple the bit lines to the cell. For example, as depicted in FIG. 3, a word line voltage can be set high to turn on nMOS access transistors.

In one approach, the write driver is configured to drive one selected pair of the bit lines of a column based on signals from the column decoder and according to the subset of memory cells involved in the write operation.

In a read operation, a pair of bit lines are pre-charged to the same level, typically a power supply voltage Vcc. The word line voltage is then set to couple the bit lines to the cell, causing one of the bit lines to discharges while the other bit line remains at the pre-charged level. A sense amplifier coupled to the pair of bit lines senses a small voltage difference between the bit lines and outputs a corresponding bit of data on output paths 281.

FIG. 3 depicts a circuit diagram of an example six-transistor (6T) Static Random-Access Memory (SRAM) cell 300, consistent with any of the memory cells of FIG. 2, according to various embodiments. The cell includes left and right bit line access transistors, AXL and AXR, respectively, coupled to a bit line BL and a complementary bit line BLB, respectively, and to back-to-back inverters INV1 and INV2, respectively. AXL is an access transistor of INV1 (a first access transistor), and AXR is an access transistor of INV2 (a second access transistor). INV1 includes a pMOS transistor PU1 and an nMOS transistor PD1 in series. A source 302 of PU1 is coupled to a power supply node 301 at Vcc, a drain of PU1 at node 303 is coupled to a drain of PD1 at node 303 (N0) and a source 304 of PD1 is coupled to ground. PU1 and PD1 have their control gates 320 and 321, respectively, coupled to one another by a path 305 (RL1), which is also coupled to a node 311 (N1) by a path 306.

INV2 includes a pMOS transistor PU2 and an nMOS transistor PD2 in series. A source 310 of PU2 is coupled to a power supply node 309 at Vcc, a drain of PU2 at a node 311 is coupled to a drain of PD2 at node 311 and a source 312 of PD2 is coupled to ground. PU2 and PD2 have their control gates 322 and 323, respectively, coupled to one another by a path 308 (RR1), which is also coupled to the node 303 (N0) by a path 307.

A conductive path 324 is a word line (WL) which connects the control gate 325 of AXL to the control gate 326 of AXR.

The cell 300 is among many other memory cells in a column, and BL and BLB represent a bit line pair which is among multiple bit line pairs associated with the column.

While a 6T implementation is discussed, other implementations are possible such as an 8T SRAM cell.

As mentioned, a memory array is addressed using the word lines, and data is transferred into or out of the array using the bit lines. For example, a selected word line can be driven to a high level to turn on the access transistors AXL and AXR, thereby connecting the pair of cross-connected inverters to the primary bit line BL and the complementary bit line, BLB. The other rows in the memory array are disconnected from the bit lines and do not participate in the read or write cycle since their word line voltages are low.

When reading a cell, the inverters drive the bit lines - one high and one low - and sense circuitry (a sense amplifier) compares the voltages on the two bit lines to decide whether the bit is a zero or a one. When writing a cell, a write driver drives the bit lines - again, one high and one low for each cell. The write driver is stronger than the inverters in the memory cell, and can therefore impose a new state on the memory cell. At the end of the cycle, the word line is deactivated and the cells retain their state.

Bit line pre-charging occurs during read and write operations to improve the speed and reliability of accessing data stored in the memory cells. Before a read or write operation, the bit lines are pre-charged to a known voltage level, usually Vcc, the supply voltage. Pre-charging is done using pre-charge transistors connected between the bit lines and a supply voltage source. When these transistors are activated, they equalize the voltage on BL and BLB to Vcc.

In a read operation, after the pre-charging, a selected word line is activated, connecting the SRAM cell to the bit lines. Depending on the stored value (0 or 1), the SRAM cell pulls one of the bit lines low, creating a small differential voltage between BL and BLB that is sensed by the sense amplifier.

During a write, after pre-charging, the bit lines are driven to the desired data levels (one high, the other low), and the word line is activated to write the data into the SRAM cell.

The pre-charging phase should be completed before the word line is activated to ensure that the bit lines are properly prepared for the subsequent read or write operation.

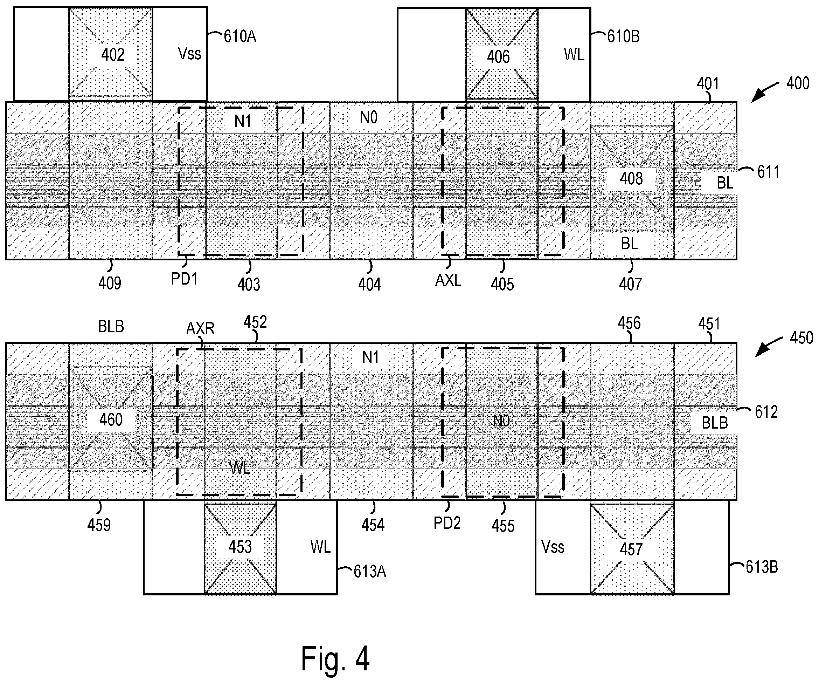

FIG. 4 depicts an example layout of the n-type transistor layer 130 of FIG. 1, consistent with the memory cell 300 of FIG. 3, according to various embodiments. This is the front side of the memory device. The front-side nMOS layer contains four nNMOS devices distributed across two rows in an n-type transistor layer. The nMOS access transistors AXL1 and AXR1 are connected to BL and BLB, respectively.

The n-type transistors of the cell are in the n-type transistor layer 130 and the p-type transistors of the cell are in the p-type transistor layer 120. Two spaced apart n-type transistor regions 400 and 450 comprise substrates 401 and 451, respectively, comprising e.g., p-type silicon with doped n-type areas which form source/drain nodes of nMOS transistors. The layout is shown in an x-y plane which is parallel to a plane of the substrate on which the layers are formed. In particular, the region 400 includes nMOS transistors PD1 and AXL and the region 450 includes nMOS transistors AXR and PD2.

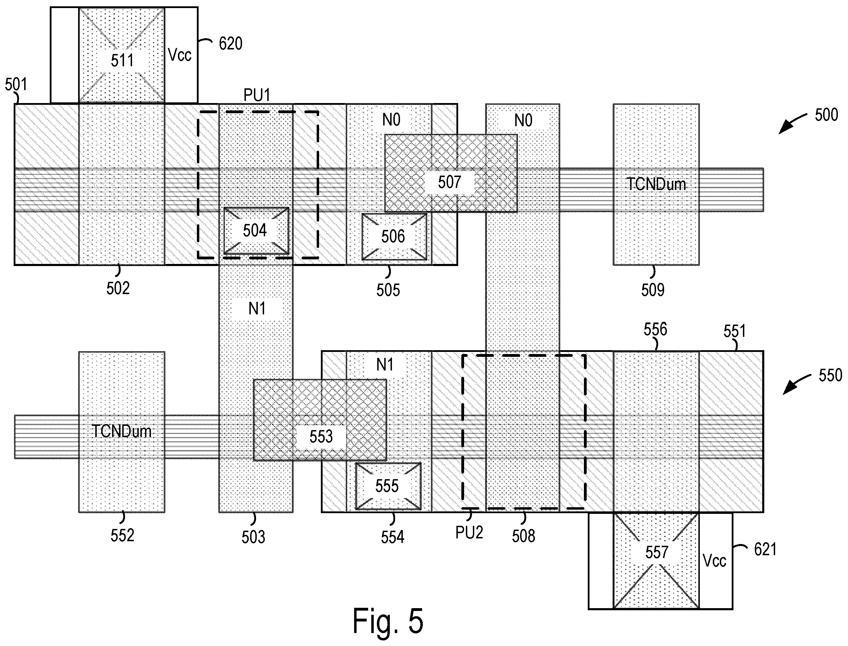

Each transistor has laterally opposing source/drain terminals or regions in the n-type transistor region, and an overlying control gate. Conductive paths are formed between the transistors and in top and bottom metal layers to provide interconnects. Some conductive paths can extend laterally in the plane of the n-type transistor regions (the x-y plane) and can comprise doped polysilicon (poly), for instance. One type of lateral conductive path can extend from an area which overlays a source/drain terminal of a transistor in the n-type transistor region to an area which is external to the n-type transistor region, to provide an area for a via to be located. The vias can extend upwards to one or more top metal layers, or downwards to the p-type transistor layer of FIG. 5, for example. The vias can be metal plated through-vias, for example, or other conductive material. Another type of lateral conductive path extends directly between the two nMOS regions 400 and 450.

A common word line, WL, controls the access transistors AXL and AXR. The nMOS regions 400 and 450 are associated with bit lines BL and BLB, respectively.

In the region 400, a conductive path 409 overlies a source/drain region of PD1 and is coupled up by a via 402 to a M0 portion 610A for Vss. A conductive path 403 forms a control gate of PD1 and represents the N1 node. It is coupled down to the p-type transistor layer of FIG. 5. A conductive path 404 overlies a source/drain region of PD2 and AXL and represents the node N0. It is coupled down to the p-type transistor layer of FIG. 5. A conductive path 405 forms a control gate of AXL and is coupled up by a via 406 to a M0 portion 610B for WL. A conductive path 407 overlies a source/drain region of AXL and is coupled up by a via 408 to an M0 portion 611 for BL.

In the region 450, a conductive path 459 overlies a source/drain region of AXR and is coupled up by a via 460 to a M0 portion 612 for BLB. A conductive path 452 forms a control gate of AXR and is coupled up by a via 453 to a M0 portion 613A for WL. A conductive path 454 overlies a source/drain region of AXR and PD2 and represents the node N1. It is coupled down to the p-type transistor layer of FIG. 5. A conductive path 455 forms a control gate of PD2 and represents the N0 node. It is coupled down to the p-type transistor layer of FIG. 5. A conductive path 456 overlies a source/drain region of PD2 and is coupled up by a via 457 to an M0 portion 613B for Vss.

FIG. 5 depicts an example layout of the p-type transistor layer 130 of FIG. 1, consistent with the layout of the n-type transistor layer of FIG. 4, according to various embodiments. This is the back side of the memory device and is positioned directly under the n-type transistor layer, in one approach. Although there are only two pMOS devices, two rows are used since the internal nodes of the SRAM, N0 and N1, cannot be placed at the boundary of the cell. Instead, there are empty spaces for dummy pMOS transistors.

Two spaced apart p-type transistor regions 500 and 550 comprise substrates 501 and 551, respectively, comprising e.g., n-type silicon with doped p-type areas which form source/drain nodes of pMOS transistors. In particular, regions 500 and 550 include pMOS transistors PU1 and PU2, respectively.

Each transistor has laterally opposing source/drain terminals or regions in the p-type transistor region, and an overlying control gate. In the region 500, a conductive path 502 overlies a source/drain region of PU1 and is coupled down by a via 511 to a BM0 portion 620 for Vcc. A conductive path 503 forms a control gate of PU1, represents the N1 node, extends to the pMOS region 550, and is coupled up by a via 504 to the overlying conductive path 403 in FIG. 4. A conductive path 505 overlies a source/drain region of PU1, represents the node N0, and is coupled up by a via 506 to the overlying conductive path 404 in FIG. 4. A gate connect node (GCN) 507 couples the conductive path 505 to the conductive path 508, which represents the N0 node and extends to the pMOS region 550. A dummy trench contact node (TCNDum) 509 is also formed, but not used, for consistency with the nMOS layer.

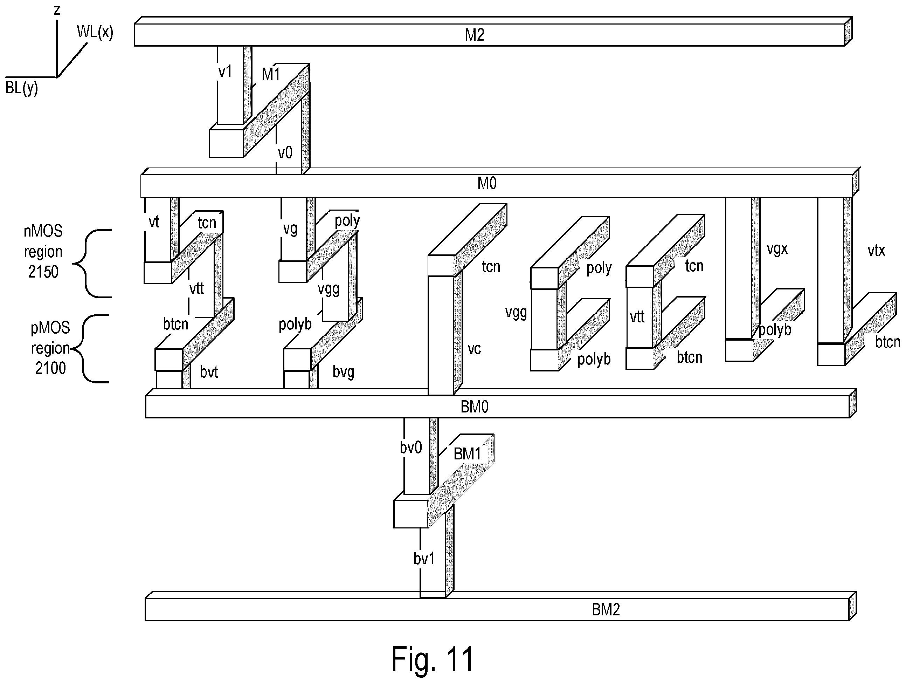

A GCN can connect a polysilicon conductive path which forms a control gate to a conductive path which is a trench contact node, for instance. For example, see conductive paths poly and tcn in FIG. 11.

In the region 550, a dummy trench contact node 552 is formed. A GCN 553 is used to couple the conductive path 503 to the conductive path 554. The conductive path 554 overlies a source/drain region of PU2 and is coupled up by a via 555 to the overlying conductive path 454 in FIG. 4. The conductive path 508 forms a control gate of PU2. A conductive path 556 overlies a source/drain region of PU2 and is coupled down by a via 557 to a BM0 portion 621 for Vcc.

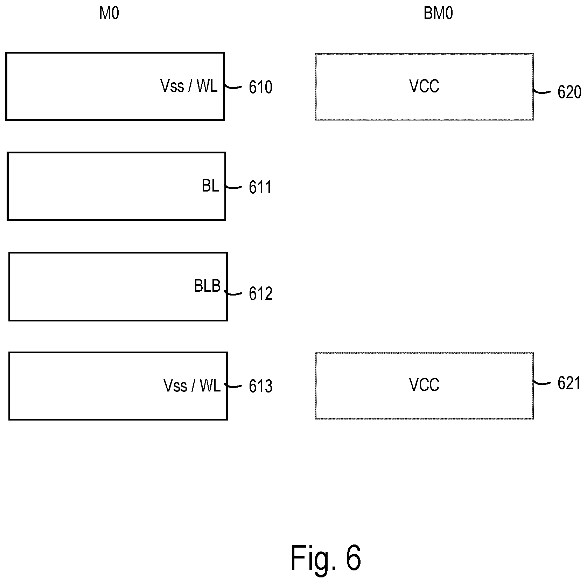

FIG. 6 depicts an example layout of front and back side metal layers M0 and BM0, respectively, consistent with FIGs. 4 and 5, where the bit lines are in M0 portions, according to various embodiments. In particular, the M0 portions 610, 611, 612 and 613 are used for Vss or WL, BL, BLB and Vss or WL, respectively. The BM0 portions 620 and 621 are used for Vcc.

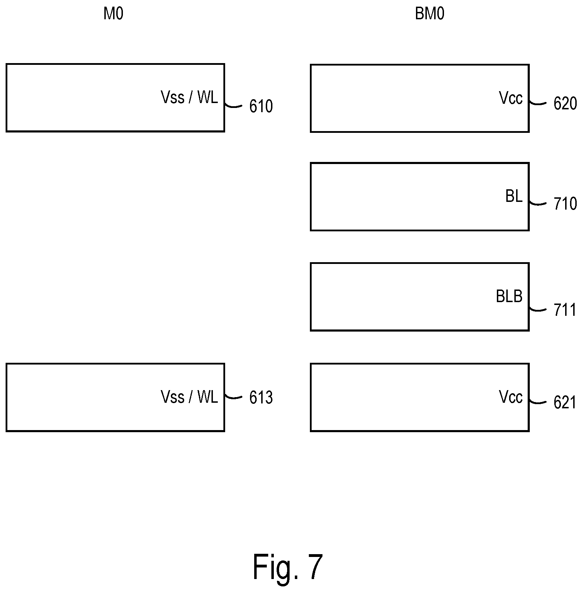

FIG. 7 depicts another example layout of front side and back side metal layers M0 and BM0, respectively, consistent with FIGs. 4 and 5, where the bit lines are in BM0 portions, according to various embodiments. The M0 portions 610 and 613 are used for Vss or WL as in FIG. 6, but the BL and BLB are implemented in BM0 portions 710 and 711, respectively, instead of M0 portions. The bit lines are thus moved from the top to the bottom of the stack. The BM0 portions 620 and 621 are again used for Vcc.

FIG. 8A depicts an example column of memory cells 800 which has first and second sets of bit lines 801 and 802, respectively, and associated first and second pre-charge circuits 821 and 822, respectively, according to various embodiments. The column includes a set of memory cells 810, e.g., cell[0]-cell[255], where a first subset of the memory cells 811 includes cell[0]-cell[M-1] in rows R[0]-R[M-1], respectively, and a second subset of the memory cells 812 includes cell[M]-cell[255] in rows R[M]-R[255], respectively. This example assumes there are 256 rows in the array, but other implementations are possible. M is a number which indicates the number of cell in the first subset of the memory cells 811 and, in this example, 256-M is the number of cells in the second subset of the memory cells 812. Each set of bit lines comprises a pair of bit lines, in one approach. One bit line may be a primary bit line and the other bit line may be a complementary bit line.

The first and second sets of bit lines are coupled to the first and second subsets of the memory cells, respectively. In one approach, the first subset of memory cells of the column of memory cells is coupled to the first set of bit lines but not the second set of bit lines, and a second subset of memory cells of the column of memory cells is coupled to the second set of bit lines but not the first set of bit lines.

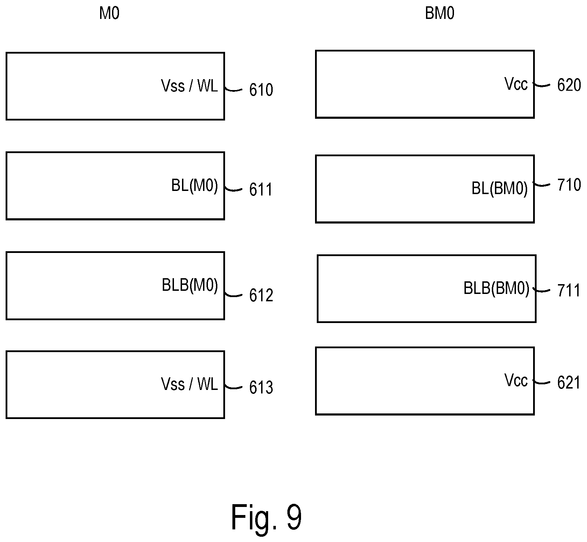

The first set of bit lines includes BL(M0) and BLB(M0), indicating these bit lines are formed by metal portions in the M0 layer, consistent with the M0 portions 611 and 612, respectively, of FIG. 9. The second set of bit lines includes BL(BM0) and BLB(BM0), indicating these bit lines are formed by metal portions in the BM0 layer, consistent with the BM0 portions 710 and 711 of FIG. 9.

First and second pre-charge circuits 821 and 822 are coupled to one end of the first and second sets of bit lines, respectively. The circuits 821 and 822 can pre-charge the bit lines during read and write operations for the first and second sets of bit lines, respectively. A write driver is coupled to the other end of the first and second sets of bit lines.

A multiplexer 815 can select one set of bit lines (based on a select signal) to couple to a sense circuit 816 (e.g., sense amplifier) during a read operation. The multiplexer has an input side 815a coupled to the first and second sets of bit lines of each column and an output side 815b coupled to the multiplexer 815.

The bit line capacitance associated with a memory cell depends on a distance between the cell and the sense circuit. A longer distance corresponds to a higher capacitance and higher resistance. A distance from the subset of memory cells 811 to the sense circuit is larger than the distance from the subset of memory cells 812 to the sense circuit, on average. Generally, the time to stabilize a signal transmitted by the pre-charge circuit and received at a portion of the bit lines which is adjacent to a selected memory cell (e.g., at the access transistors of the selected memory cell) is longer when the capacitance of the bit lines is greater (e.g. the distance traversed by the signal on the bit lines is greater).

With a generic design of M cells with M0 BL/BLB and 256-M cells with BM0 BL/BLB, M can be optimized to balance the capacitance between both types of bit lines. For example, BM0 may have a 10% higher capacitance and 25% lower resistance compared to M0. Also, out of the total capacitance of the bit lines, there is a 30% contribution from the diffusion and 70% from the metal. With these assumption: Mx0.3 + 256 x 0.7 = (256-M)x0.3 + (256-M)*0.7*1.1. Solving this equation results in a M value of 69.1 or rounded to 69. This results in 69 bit-cells connected to M0 BL/BLB and 187 bit-cells connected to BM0 BL/BLB. Hence the capacitance in M0 BL/BLB is 200 and capacitance in BM0 BL/BLB is also 200. The baseline capacitance with only M0 BL/BLB is 256. The improvement in the capacitance of 22% can be traded off with lower power or more number of bits per bit-line.

Moreover, by separating the pre-charge circuits/logic for the first and second sets of bit lines, the M0 bit lines can be pre-charged while the BM0 bit lines undergo read or write operations, for example. Or, the BM0 bit lines can be pre-charged while M0 bit lines undergo read or write operations. In case the access to M0 bit lines is followed by access to the BM0 bit lines, a time savings can be achieved if the pre-charge of the BM0 bit lines occurs in parallel with the pre-charge of the M0 bit lines. This can only be exploited by a specific memory access pattern.

In one approach, there is an equalized capacitance on the bit lines so that the pre-charge time will be very similar on the different sets of bit lines. However, in another design approach, different capacitances can be provided for the different sets of bit lines which can then be used for non-uniform pre-charge times. For example, the pre-charge time for the BM0 bit lines can be less than the pre-charge time for the M0 bit lines since the first subset of cells 811 are closer to the respective pre-charge circuit 822 on average compared to a distance of the second subset of cells 812 from the respective pre-charge circuit 821.

In one approach, the first pre-charge circuit is to pre-charge the first set of bit lines for a first time period before at least one of a read or write operation involving the first subset of memory cells; and the second pre-charge circuit is to pre-charge the second set of bit lines for a second time period, different than the first time period, before at least one of a read or write operation involving the second subset of memory cells. A distance between a sense circuit and the first subset of memory cells on average is greater than a distance between the sense circuit and the second subset of memory cells on average; and the first time period is greater than the second time period.

The number of cells in the first and second groups can be different. In one approach, there are fewer cells in the first set of memory cells than in the second set of memory cells.

FIG. 8B depicts an example timeline for a read or write operation in the column of FIG. 8A, according to various embodiments. In this example, a time t1 allocated for pre-charge is the same for the two sets of bit lines. Also, a time t2 allocated for a read or write operation which follows the pre-charge is the same for the two sets of bit lines. The timeline shows that, advantageously, read or write operations can be performed concurrently, at least in part, for the two sets of bit lines/memory cells.

FIG. 8C depicts another example timeline for a read or write operation in the column of FIG. 8A, according to various embodiments. In this example, a time t1a allocated for pre-charge for the second sets of bit lines is less than the time t1 allocated for pre-charge for the first sets of bit lines, due to the reduced capacitance of the second set of bit lines which allows the pre-charge voltage to be established more quickly.

T1b denotes a time period in which the first set of bit lines is pre-charged while the second set of memory cells undergoes a read or write operation.

In one possible implementation, a write operation is performed on the first set of memory cells while a read operation is performed on the second set of memory cells, or vice-versa.

See also FIG. 12B for example timelines in the case of three sets of bit lines.

FIG. 9 depicts an example layout of front and back side metal layers M0 and BM0, respectively, consistent with FIG. 8, where the first and second sets of bit lines 801 and 802 are in M0 and BM0 portions, respectively, according to various embodiments. As in FIG. 6, M0 portions 610, 611, 612 and 613 are used for Vss or WL, BL, BLB and Vss or WL, respectively. The BM0 portions 620 and 621 are used for Vcc, while BL and BLB are implemented in the BM0 portions 710 and 711, respectively. The first set of bit lines are thus implemented in a top metal layer, e.g., M0, and the second set of bit lines are implemented in a bottom metal layer, e.g., BM0. The reverse case is possible as well.

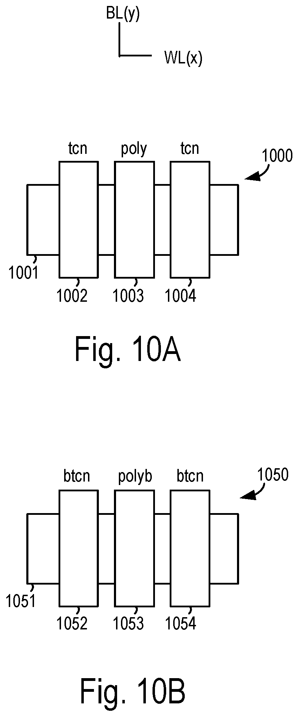

FIG. 10A depicts a layout of control gate and source/drain paths of an n-type transistor layer consistent with FIG. 4, according to various embodiments. The layout 1000 includes an active area 1001 and conductive paths tcn 1002, poly 1003, and tcn 1004, which extend over the active area.

FIG. 10B depicts a layout of control gate and source/drain paths of a p-type transistor layer consistent with FIG. 5, according to various embodiments. The layout 1050 includes an active area 1051 and conductive paths btcn 1052, polyb 1053, and btcn 1054, which extend over the active area.

FIG. 11 depicts an example perspective view of different metal layers and vias in an SRAM device, consistent with FIGs. 8-10B, in accordance with various embodiments.

The conductive paths can include vias which extend in the z direction, and lateral paths which extend in the WL(x) or BL(y) direction. Transistor regions 2100 and 2150 are associated with the conductive paths in the bottom (pMOS) and top (nMOS) layers, respectively of the CFET device.

This example includes first, second and third bottom metal layers BM0, BM1 and BM2, respectively, below the transistor region 2100. BM0 and BM2 extend in the BL(y) direction and BM1 extends in the WL(x) direction. First, second and third top metal layers M0, M1 and M2, respectively, are above the top transistor region 2150. M0 and M2 extend in the BL(y) direction, and M1 extends in the WL(x) direction.

A via bv1 extends up from BM2 to BM1, and a via bv0 extends up from BM1 to BM0. A via bvt extends up from BM0 to a trench contact node btcn, and a via bvg extends up from BM0 to a polysilicon path polyb in the transistor region 2100. A via vcp extends up from BM0 to tcn in the transistor region 2150.

A via vtt extends up from btcn to tcn, and a via vgg extends up from polyb to poly, in the transistor region 2150.

A via vt extends up from tcn to M0 and a via vg extends up from poly to M0. A via vgx extends down from M0 to polyb, and a via vtx extends down from M0 to btcn.

A via vgg extends up from polyb in the pMOS region to poly in the nMOS region, and a via vtt extends up from btcn in the pMOS region to tcn in the nMOS region.

A via v0 extends up from M0 to M1, and a via v1 extends up from M1 to M2.

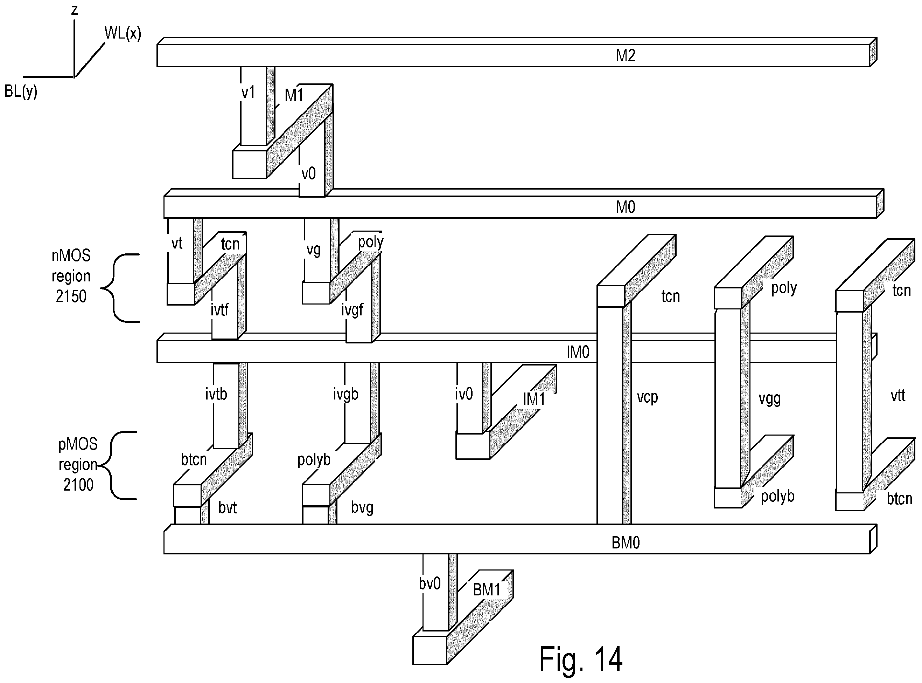

The conductive paths in the CFET devices of FIGs. 4 and 5 can be understood further in view of FIG. 14. For example, in FIGs. 4 and 6, the vias 402, 408, 460 and 457 correspond to vt, and the vias 406 and 453 correspond to vg.

In FIGs. 4 and 7, the vias 402 and 457 correspond to vt, the vias 406 and 453 correspond to vg, and the vias 408 and 460 correspond to vcp.

FIG. 12A depicts an example column of memory cells which has first, second and third sets of bit lines 1201, 1202 and 1203, respectively, and associated first, second and third pre-charge circuits 1223, 1222 and 1221, respectively, according to various embodiments.

The column includes memory cells 1210, where a first subset of the memory cells 1211 includes cell[0]-cell[M-1] in rows R[0]-R[M-1], respectively, a second subset of the memory cells 1212 includes cell[M]-cell[N-1] in rows R[M]-R[N-1], respectively, and a third subset of the memory cells 1213 includes cell[N]-cell[255] in rows R[N]-R[255], respectively. This example assumes there are 256 rows in the array, but other implementations are possible. M and N are numbers which indicate the number of rows in the first and second subsets, respectively, of the memory cells 1211. M can be equal to, less than or greater than N.

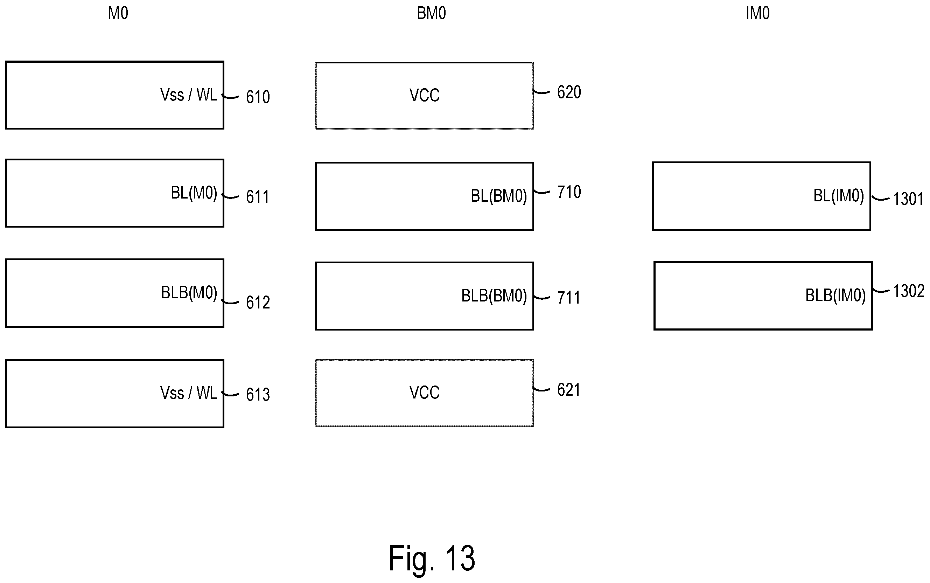

The first, second and third sets of bit lines are coupled to the first, second and third subsets of the memory cells, respectively. The first set of bit lines includes BL(M0) and BLB(M0), indicating these bit lines are formed by metal portions in the M0 layer, consistent with the M0 portions 611 and 612, respectively, of FIG. 13. The second set of bit lines includes BL(BM0) and BLB(BM0), indicating these bit lines are formed by metal portions in the BM0 layer, consistent with the BM0 portions 710 and 711, respectively, of FIG. 13. The third set of bit lines includes BL(IM0) and BLB(IM0), indicating these bit lines are formed by metal portions in the IM0 layer, consistent with the IM0 portions 1310 and 1302, respectively, of FIG. 13.

The first, second and third pre-charge circuits 1223, 1222 and 1221 are coupled to the first, second and third sets of bit lines, respectively. The circuits 1223, 1222 and 1221 can pre-charge the associated bit lines during read and write operations for the first, second and third sets of bit lines, respectively.

A multiplexer 1225 can select one set of bit lines (based on a select signal) to couple to a sense circuit 1216 (e.g., sense amplifier) during a read operation.

In this example, the bit line capacitance is lower for the second set of bit lines than for the third set, and lower for the third set than the first set. The use of three sets of bit lines provides even more flexibility for concurrent operations and improved performance.

FIG. 12B depicts an example timeline for a read or write operation in the column of FIG. 12A, according to various embodiments. In this example, the time allocated for pre-charge for the first, second and third sets of bit lines is t1, t2 and t3, respectively, where t1>t3>t2, due to the reduced capacitance of the first set of bit lines which allows the pre-charge voltage to be established more quickly than for the second set, and more quickly for the second set compared to the third set.

FIG. 13 depicts an example layout of front, back and intermediate metal layers consistent with FIG. 12A, where the bit lines BL(M0), BL(BM0) and BL(IM0) are in M0, BM0 and IM0 metal layer portions, respectively, according to various embodiments. M0 portions 610, 611, 612 and 613 are provided for Vss or WL, BL(M0), BLB(M0) and Vss or WL, respectively. BM0 portions 620, 710, 711 and 621 are provided for Vcc, BL(BM0), BLB(BM0) and Vcc, respectively. IM0 portions 1301 and 1302 are provided for BL(IM0) and BLB(IM0), respectively.

Compared to FIG. 9, an additional metal layer IM0 is used for the third set of bit lines.

FIG. 14 depicts an example perspective view of different metal layers and vias in an SRAM device, consistent with FIGs. 10A-13, in accordance with various embodiments. As in FIG. 11, transistor regions 2100 and 2150 are associated with the conductive paths in the bottom (pMOS) and top (nMOS) layers, respectively of the CFET device.

This example includes first and second bottom metal layers BM0 and BM1, respectively, below the transistor region 2100. BM0 and BM1 extend in the BL(y) and WL(x) directions, respectively. First, second and third top metal layers M0, M1 and M2, respectively, are above the top transistor region 2150. First and second intermediate metal layers IM0 and IM1, respectively, are between the bottom and top transistor regions. IM0 extends in the BL(y) direction and IM1 extends in the WL(x) direction.

A via bv0 extends up from BM1 to BM0. A via bvt extends up from BM0 to a trench contact node btcn, and a via bvg extends up from BM0 to a polysilicon path polyb in the transistor region 2100. Polyb and btcn can also be used as lateral paths within the transistor region 2100 which do not connect to a via. Also, as shown, a via vgg can extend up from polyb in the pMOS region to poly in the nMOS region, and a via vtt can extend up from btcn in the pMOS region to tcn in the nMOS region.

A via ivtb extends up from btcn to IM0. A via ivgb extends up from polyb to IM0. A via iv0 extends down from IM0 to IM1.

A via ivtf extends up from IM0 to a trench contact node tcn in the transistor region 2150. A via ivgf extends up from IM1 to poly in the transistor region 2150. Tcn can also be used as lateral path within the transistor region 2150 which does not connect to a via.

A via v0 extends up from M0 to M1, and a via v1 extends up from M1 to M2.

The conductive paths in the CFET devices of FIGs. 12 and 13 can be understood further in view of these metal layers and vias. A via vcp connects between tcn and BM0 which is used for connecting to the second set of bit lines 710 and 711 (FIG. 13) which is routed in BM0.

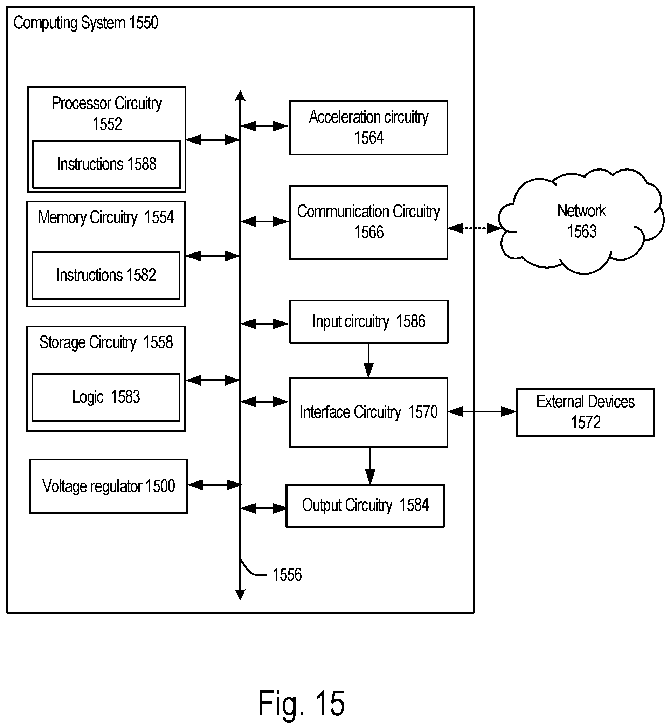

FIG. 15 illustrates an example of components that may be present in a computing system 1550 for implementing the techniques (e.g., operations, processes, methods, and methodologies) described herein.

The computing system 1550 may include any combinations of the hardware or logical components referenced herein. The components may be implemented as ICs, portions thereof, discrete electronic devices, or other modules, instruction sets, programmable logic or algorithms, hardware, hardware accelerators, software, firmware, or a combination thereof adapted in the computing system 1550, or as components otherwise incorporated within a chassis of a larger system. In an example implementation, the CFET device is provided one or more of the processor circuitry 1552, memory circuitry 1554, storage circuitry 1558, voltage regulator 1500, acceleration circuitry 1564, communication circuitry 1566, input circuitry 1586, interface circuitry 1570, external devices 1572 or output circuitry 1584. In one approach, all or part of the computing system 1550 is provided in a SoP, System in Package (SiP) or a System on Chip (SoC).

In one approach, all or part of the computing system 1050 is provided in a SoP, System in Package (SiP) or a System on Chip (SoC).

The voltage regulator can provide a voltage Vout to one or more of the components of the computing system 1050. The memory circuitry 1054 may store instructions and the processor circuitry 1052 may execute the instructions to perform the functions described herein.

The system 1050 includes processor circuitry in the form of one or more processors 1052. The processor circuitry 1052 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multimedia card (SD/MMC) or similar, interfaces, mobile industry processor interface (MIPI) interfaces and Joint Test Access Group (JTAG) test access ports. In some implementations, the processor circuitry 1052 may include one or more hardware accelerators (e.g., same or similar to acceleration circuitry 1064), which may be microprocessors, programmable processing devices (e.g., FPGA, ASIC, etc.), or the like. The one or more accelerators may include, for example, computer vision and/or deep learning accelerators. In some implementations, the processor circuitry 1052 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein
The processor circuitry 1052 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multi-core processor, a multithreaded processor, an ultra-low-voltage processor, an embedded processor, or any other known processing elements, or any suitable combination thereof. The processors (or cores) 1052 may be coupled with or may include memory/storage and may be configured to execute instructions stored in the memory/storage to enable various applications or operating systems to run on the platform 1050. The processors (or cores) 1052 is configured to operate application software to provide a specific service to a user of the platform 1050. In some embodiments, the processor(s) 1052 may be a special-purpose processor(s)/controller(s) configured (or configurable) to operate according to the various embodiments herein.

As examples, the processor(s) 1052 may include an Intel^{®} Architecture Core^{™} based processor such as an i3, an i5, an i7, an i9 based processor; an Intel^{®} microcontroller-based processor such as a Quark^{™}, an Atom^{™}, or other MCU-based processor; Pentium^{®} processor(s), Xeon^{®} processor(s), or another such processor available from Intel^{®} Corporation, Santa Clara, California. However, any number other processors may be used, such as one or more of Advanced Micro Devices (AMD) Zen^{®} Architecture such as Ryzen^{®} or EPYC^{®} processor(s), Accelerated Processing Units (APUs), MxGPUs, Epyc^{®} processor(s), or the like; A5-A12 and/or S1-S4 processor(s) from Apple^{®} Inc., Snapdragon^{™} or Centriq^{™} processor(s) from Qualcomm^{®} Technologies, Inc., Texas Instruments, Inc.^{®} Open Multimedia Applications Platform (OMAP)^{™} processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2^{®} provided by Cavium^{™}, Inc.; or the like. In some implementations, the processor(s) 1052 may be a part of a system on a chip (SoC), System-in-Package (SiP), a multi-chip package (MCP), and/or the like, in which the processor(s) 1052 and other components are formed into a single integrated circuit, or a single package, such as the Edison^{™} or Galileo^{™} SoC boards from Intel^{®} Corporation. Other examples of the processor(s) 1052 are mentioned elsewhere in the present disclosure.

The system 1050 may include or be coupled to acceleration circuitry 1064, which may be embodied by one or more AI/ML accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/ML processing (e.g., including training, inferencing, and classification operations), visual data processing, network data processing, object detection, rule analysis, or the like. In FPGA-based implementations, the acceleration circuitry 1064 may comprise logic blocks or logic fabric and other interconnected resources that may be programmed (configured) to perform various functions, such as the procedures, methods, functions, etc. of the various embodiments discussed herein. In such implementations, the acceleration circuitry 1064 may also include memory cells (e.g., EPROM, EEPROM, flash memory, static memory (e.g., SRAM, anti-fuses, etc.) used to store logic blocks, logic fabric, data, etc. in LUTs and the like.

In some implementations, the processor circuitry 1052 and/or acceleration circuitry 1064 may include hardware elements specifically tailored for machine learning and/or artificial intelligence (AI) functionality. In these implementations, the processor circuitry 1052 and/or acceleration circuitry 1064 may be, or may include, an AI engine chip that can run many different kinds of AI instruction sets once loaded with the appropriate weightings and training code. Additionally or alternatively, the processor circuitry 1052 and/or acceleration circuitry 1064 may be, or may include, AI accelerator(s), which may be one or more of the aforementioned hardware accelerators designed for hardware acceleration of AI applications. As examples, these processor(s) or accelerators may be a cluster of artificial intelligence (AI) GPUs, tensor processing units (TPUs) developed by Google^{®} Inc., Real AI Processors (RAPs^{™}) provided by AlphalCs^{®}, Nervana^{™} Neural Network Processors (NNPs) provided by Intel^{®} Corp., Intel^{®} Movidius^{™} Myriad^{™} X Vision Processing Unit (VPU), NVIDIA^{®} PX^{™} based GPUs, the NM500 chip provided by General Vision^{®}, Hardware 3 provided by Tesla^{®}, Inc., an Epiphany^{™} based processor provided by Adapteva^{®}, or the like. In some embodiments, the processor circuitry 1052 and/or acceleration circuitry 1064 and/or hardware accelerator circuitry may be implemented as AI accelerating co-processor(s), such as the Hexagon 685 DSP provided by Qualcomm^{®}, the PowerVR 2NX Neural Net Accelerator (NNA) provided by Imagination Technologies Limited^{®}, the Neural Engine core within the Apple^{®} A11 or A12 Bionic SoC, the Neural Processing Unit (NPU) within the HiSilicon Kirin provided by Huawei^{®}, and/or the like. In some hardware-based implementations, individual subsystems of system 1050 may be operated by the respective AI accelerating co-processor(s), AI GPUs, TPUs, or hardware accelerators (e.g., FPGAs, ASICs, DSPs, SoCs, etc.), etc., that are configured with appropriate logic blocks, bit stream(s), etc. to perform their respective functions.

The system 1050 also includes system memory 1054. Any number of memory devices may be used to provide for a given amount of system memory. As examples, the memory 1054 may be, or include, volatile memory such as random access memory (RAM), static RAM (SRAM), dynamic RAM (DRAM), synchronous DRAM (SDRAM), RAMBUS^{®} Dynamic Random Access Memory (RDRAM^{®}), and/or any other desired type of volatile memory device. Additionally or alternatively, the memory 1054 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 1054 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 1058 provides persistent storage of information such as data, applications, operating systems and so forth. In an example, the storage 1058 may be implemented via a solid-state disk drive (SSDD) and/or high-speed electrically erasable memory (commonly referred to as "flash memory"). Other devices that may be used for the storage 1058 include flash memory cards, such as SD cards, microSD cards, XD picture cards, and the like, and USB flash drives. In an example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 1054 and/or storage circuitry 1058 may also incorporate three-dimensional (3D) cross-point (XPOINT) memories from Intel^{®} and Micron^{®}.

The memory circuitry 1054 and/or storage circuitry 1058 is/are configured to store computational logic 1083 in the form of software, firmware, microcode, or hardware-level instructions to implement the techniques described herein. The computational logic 1083 may be employed to store working copies and/or permanent copies of programming instructions, or data to create the programming instructions, for the operation of various components of system 1050 (e.g., drivers, libraries, application programming interfaces (APIs), etc.), an operating system of system 1050, one or more applications, and/or for carrying out the embodiments discussed herein. The computational logic 1083 may be stored or loaded into memory circuitry 1054 as instructions 1082, or data to create the instructions 1082, which are then accessed for execution by the processor circuitry 1052 to carry out the functions described herein. The processor circuitry 1052 and/or the acceleration circuitry 1064 accesses the memory circuitry 1054 and/or the storage circuitry 1058 over the interconnect (IX) 1056. The instructions 1082 direct the processor circuitry 1052 to perform a specific sequence or flow of actions, for example, as described with respect to flowchart(s) and block diagram(s) of operations and functionality depicted previously. The various elements may be implemented by assembler instructions supported by processor circuitry 1052 or high-level languages that may be compiled into instructions 1088, or data to create the instructions 1088, to be executed by the processor circuitry 1052. The permanent copy of the programming instructions may be placed into persistent storage devices of storage circuitry 1058 in the factory or in the field through, for example, a distribution medium (not shown), through a communication interface (e.g., from a distribution server (not shown)), over-the-air (OTA), or any combination thereof.

The IX 1056 couples the processor 1052 to communication circuitry 1066 for communications with other devices, such as a remote server (not shown) and the like. The communication circuitry 1066 is a hardware element, or collection of hardware elements, used to communicate over one or more networks 1063 and/or with other devices. In one example, communication circuitry 1066 is, or includes, transceiver circuitry configured to enable wireless communications using any number of frequencies and protocols such as, for example, the Institute of Electrical and Electronics Engineers (IEEE) 802.11 (and/or variants thereof), IEEE 802.23.4, Bluetooth^{®} and/or Bluetooth^{®} low energy (BLE), ZigBee^{®}, LoRaWAN^{™} (Long Range Wide Area Network), a cellular protocol such as 3GPP LTE and/or Fifth Generation (5G)/New Radio (NR), and/or the like. Additionally or alternatively, communication circuitry 1066 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others.

The IX 1056 also couples the processor 1052 to interface circuitry 1070 that is used to connect system 1050 with one or more external devices 1072. The external devices 1072 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 1050, which are referred to as input circuitry 1086 and output circuitry 1084. The input circuitry 1086 and output circuitry 1084 include one or more user interfaces designed to enable user interaction with the platform 1050 and/or peripheral component interfaces designed to enable peripheral component interaction with the platform 1050. Input circuitry 1086 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 1084 may be included to show information or otherwise convey information, such as sensor readings, actuator position(s), or other like information. Data and/or graphics may be displayed on one or more user interface components of the output circuitry 1084. Output circuitry 1084 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Crystal Displays (LCD), LED displays, quantum dot displays, projectors, etc.), with the output of characters, graphics, multimedia objects, and the like being generated or produced from the operation of the platform 1050. The output circuitry 1084 may also include speakers and/or other audio emitting devices, printer(s), and/or the like. Additionally or alternatively, sensor(s) may be used as the input circuitry 1084 (e.g., an image capture device, motion capture device, or the like) and one or more actuators may be used as the output device circuitry 1084 (e.g., an actuator to provide haptic feedback or the like). Peripheral component interfaces may include, but are not limited to, a non-volatile memory port, a USB port, an audio jack, a power supply interface, etc. In some embodiments, a display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 1050 may communicate over the IX 1056. The IX 1056 may include any number of technologies, including ISA, extended ISA, I2C, SPI, point-to-point interfaces, power management bus (PMBus), PCI, PCIe, PCIx, Intel^{®} UPI, Intel^{®} Accelerator Link, Intel^{®} CXL, CAPI, OpenCAPI, Intel^{®} QPI, UPI, Intel^{®} OPA IX, RapidIO^{™} system IXs, CCIX, Gen-Z Consortium IXs, a HyperTransport interconnect, NVLink provided by NVIDIA^{®}, a Time-Trigger Protocol (TTP) system, a FlexRay system, PROFIBUS, and/or any number of other IX technologies. The IX 1056 may be a proprietary bus, for example, used in a SoC based system.

The number, capability, and/or capacity of the elements of system 1050 may vary, depending on whether computing system 1050 is used as a stationary computing device (e.g., a server computer in a data center, a workstation, a desktop computer, etc.) or a mobile computing device (e.g., a smartphone, tablet computing device, laptop computer, game console, IoT device, etc.). In various implementations, the computing device system 1050 may comprise one or more components of a data center, a desktop computer, a workstation, a laptop, a smartphone, a tablet, a digital camera, a smart appliance, a smart home hub, a network appliance, and/or any other device/system that processes data.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

The storage medium can be a tangible, non-transitory machine readable medium such as read only memory (ROM), random access memory (RAM), flash memory devices, floppy and other removable disks, magnetic storage media, optical storage media (e.g., Compact Disk Read-Only Memory (CD ROMS), Digital Versatile Disks (DVDs)), among others.

The storage medium may be included, e.g., in a communication device, a computing device, a network device, a personal digital assistant, a manufacturing tool, a mobile communication device, a cellular phone, a notebook computer, a tablet, a game console, a set top box, an embedded system, a TV (television), or a personal desktop computer.

Some non-limiting examples of various embodiments are presented below.

Example 1 includes an apparatus, comprising: a set of memory cells arranged in a column; a first set of bit lines coupled to a first subset of memory cells of the set of memory cells; a second set of bit lines coupled to a second subset of memory cells of the set of memory cells; a first pre-charge circuit coupled to the first set of bit lines; and a second pre-charge circuit coupled to the second set of bit lines.

Example 2 includes the apparatus of Example 1, further comprising: a third set of bit lines coupled to a third subset of memory cells of the set of memory cells; and a third pre-charge circuit coupled to the third set of bit lines.

Example 3 includes the apparatus of Example 1 or 2, further comprising: a sense circuit for the column; and a multiplexer coupled on an output side to the sense circuit and on an input side to the first and second sets of bit lines.

Example 4 includes the apparatus of any one of Examples 1-3, wherein: the first pre-charge circuit is to pre-charge the first set of bit lines for a first time period before at least one of a read or write operation involving the first subset of memory cells; and the second pre-charge circuit is to pre-charge the second set of bit lines for a second time period, different than the first time period, before at least one of a read or write operation involving the second subset of memory cells. Example 5 includes the apparatus of any one of Examples 1-4, wherein the first pre-charge circuit is to pre-charge the first set of bit lines while at least one of a read or write operation is performed on the second set of memory cells.

Example 6 includes the apparatus of any one of Examples 1-5, wherein a write operation is performed on the first set of memory cells while a read operation is performed on the second set of memory cells.

Example 7 includes the apparatus of any one of Examples 1-6, wherein: the column is in a stack: the first set of bit lines comprises metal portions in a top metal layer of the stack; and the second set of bit lines comprises metal portions in a bottom metal layer of the stack.

Example 8 includes the apparatus of any one of Examples 1-7, wherein: the memory cells comprise p-type transistors in a p-type transistor layer and n-type transistors in an n-type transistor layer; and the p-type transistor layer and the n-type transistor layer are in a stack, one layer above the other.

Example 9 includes the apparatus of Example 8, further comprising a third set of bit lines coupled to a third subset of memory cells of the set of memory cells, wherein: the column is in a stack: the first set of bit lines comprises metal portions in a top metal layer of the stack; the second set of bit lines comprises metal portions in a bottom metal layer of the stack; the third set of bit lines comprises metal portions in an intermediate metal layer of the stack; and the intermediate metal layer is between the p-type transistor layer and the n-type transistor layer.

Example 10 includes the apparatus of any one of Examples 1-9, wherein the set of memory cells are in a complementary field-effect transistor (CFET) device which is provided in at least one of an integrated circuit, a System on Chip, a System in Package or a computing device.

Example 11 includes a system, comprising: an array of static random-access memory (SRAM) cells; and a control circuit to perform at least one of a write or read operation in the array, wherein: the array comprises a column of SRAM cells; the column of memory cells comprises at least first and second pairs of bit lines; the first pair of bit lines comprises a primary bit line and a complementary bit line coupled to respective access transistors of a first subset of cells of the column; and the second pair of bit lines comprises a primary bit line and a complementary bit line coupled to the respective access transistors of a second subset of cells of the column.

Example 12 includes the system of Example 11, further comprising: a first pre-charge circuit coupled to the first pair of bit lines and configured to pre-charge the first set of bit lines for a first time period; and a second pre-charge circuit coupled to the second pair of bit lines and configured to pre-charge the first set of bit lines for a second time period which is different than the first time period.

Example 13 includes the system of Example 11 or 12, further comprising: a sense circuit for the column; and a multiplexer coupled on an output side to the sense circuit and on an input side to the first and second pairs of bit lines.

Example 14 includes the system of any one of Examples 11-13, wherein the control circuit is to perform a write operation for the first subset of memory cells via the first pair of bit lines concurrent with performing a read operation for the second subset of memory cells via the second pair of bit lines.

Example 15 includes the system of any one of Examples 11-14, wherein the control circuit is to perform a pre-charge for the first subset of memory cells via the first pair of bit lines concurrent with performing a read or write operation for the second subset of memory cells via the second pair of bit lines.

Example 16 includes a stacked structure, comprising: a p-type transistor layer; an n-type transistor layer, wherein the p-type transistor layer is below the n-type transistor layer; a column of memory cells formed by transistors in the p-type transistor layer and the n-type transistor layer; a bottom metal layer below the p-type transistor layer; and a top metal layer above the n-type transistor layer, wherein a first set of bit lines for the column of memory cells comprise portions of the top metal layer and a second set of bit lines for the column of memory cells comprise portions of the bottom metal layer.

Example 17 includes the stacked structure of Example 16, wherein: a first subset of memory cells of the column of memory cells is coupled to the first set of bit lines but not the second set of bit lines; and a second subset of memory cells of the column of memory cells is coupled to the second set of bit lines but not the first set of bit lines.

Example 18 includes the stacked structure of Example 17, further comprising: a first pre-charge circuit coupled to the first set of bit lines; and a second pre-charge circuit coupled to the second set of bit lines, wherein: the first pre-charge circuit is to pre-charge the first set of bit lines for a first time period before at least one of a read or write operation involving the first subset of memory cells; and the second pre-charge circuit is to pre-charge the second set of bit lines for a second time period, different than the first time period, before at least one of a read or write operation involving the second subset of memory cells.

Example 19 includes the stacked structure of Example 17 or 18, further comprising: an intermediate metal layer between the p-type transistor layer and the n-type transistor layer, wherein a third set of bit lines for the column of memory cells comprises portions of the intermediate metal layer, and a third subset of memory cells of the column of memory cells is coupled to the third set of bit lines but not the first and second sets of bit lines; and a third pre-charge circuit coupled to the third set of bit lines.

Example 20 includes the stacked structure of any one of Examples 16-19, wherein the memory cell is a six-transistor static random-access memory (SRAM) cell having four transistors in the n-type transistor layer and two transistors in the p-type transistor layer.

Example 21 includes a method, comprising: pre-charging a first set of bit lines using a first pre-charge circuit; and pre-charging a second set of bit lines using a second pre-charge circuit, wherein the a first set of bit lines is coupled to a first subset of memory cells a set of memory cells in a column, and the second set of bit lines is coupled to a second subset of memory cells of the set of memory cells in the column.

Example 22 includes the method of Example 21, wherein the first pre-charging is for a first time period before at least one of a read or write operation involving the first subset of memory cells, and the second pre-charge circuit is for a second time period, different than the first time period, before at least one of a read or write operation involving the second subset of memory cells.

Example 23 includes the method of Example 21 or 22, wherein the pre-charging of the first set of bit lines occurs while at least one of a read or write operation is performed on the second set of memory cells.

Example 24 includes the method of any one of Example 21-23, further comprising performing a write operation on the first set of memory cells while a read operation is performed on the second set of memory cells.

Example 25 includes an apparatus, comprising means to perform the method of any one of Examples 21-24.

Example 26 includes a machine-readable storage including machine-readable instructions which, when executed, cause a computer to implement the method of any one of Examples 21-24.

Example 27 includes a computer program comprising instructions which, when executed by a computer, cause the computer to carry out the method of any one of Examples 21-24.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/- 10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

## Claims

1. An apparatus, comprising:
a set of memory cells arranged in a column;
a first set of bit lines coupled to a first subset of memory cells of the set of memory cells;
a second set of bit lines coupled to a second subset of memory cells of the set of memory cells;
a first pre-charge circuit coupled to the first set of bit lines; and
a second pre-charge circuit coupled to the second set of bit lines.

2. The apparatus of claim 1, further comprising:
a third set of bit lines coupled to a third subset of memory cells of the set of memory cells; and
a third pre-charge circuit coupled to the third set of bit lines.

3. The apparatus of claim 1 or 2, further comprising:
a sense circuit for the column; and
a multiplexer coupled on an output side to the sense circuit and on an input side to the first and second sets of bit lines.

4. The apparatus of any one of claim 1-3, wherein:
the first pre-charge circuit is to pre-charge the first set of bit lines for a first time period before at least one of a read or write operation involving the first subset of memory cells; and
the second pre-charge circuit is to pre-charge the second set of bit lines for a second time period, different than the first time period, before at least one of a read or write operation involving the second subset of memory cells.

5. The apparatus of any one of claim 1-4, wherein the first pre-charge circuit is to pre-charge the first set of bit lines while at least one of a read or write operation is performed on the second set of memory cells.

6. The apparatus of any one of claim 1-5, wherein a write operation is performed on the first set of memory cells while a read operation is performed on the second set of memory cells.

7. The apparatus of any one of claim 1-6, wherein:
the column is in a stack:
the first set of bit lines comprises metal portions in a top metal layer of the stack; and
the second set of bit lines comprises metal portions in a bottom metal layer of the stack.

8. The apparatus of any one of claim 1-7, wherein:
the memory cells comprise p-type transistors in a p-type transistor layer and n-type transistors in an n-type transistor layer; and
the p-type transistor layer and the n-type transistor layer are in a stack, one layer above the other.

9. The apparatus of claim 8, further comprising a third set of bit lines coupled to a third subset of memory cells of the set of memory cells, wherein:
the column is in a stack:
the first set of bit lines comprises metal portions in a top metal layer of the stack;
the second set of bit lines comprises metal portions in a bottom metal layer of the stack;
the third set of bit lines comprises metal portions in an intermediate metal layer of the stack; and
the intermediate metal layer is between the p-type transistor layer and the n-type transistor layer.

10. The apparatus of any one of claim 1-9, wherein the set of memory cells are in a complementary field-effect transistor (CFET) device which is provided in at least one of an integrated circuit, a System on Chip, a System in Package or a computing device.

11. The apparatus of any one of claim 1-10, wherein the set of memory cells comprises an array of static random-access memory (SRAM) cells, the apparatus further comprising:
a control circuit to perform at least one of a write or read operation in the array.

12. The apparatus of claim 11, wherein:
a first pair of bit lines comprises a primary bit line and a complementary bit line coupled to respective access transistors of a first subset of cells of the column; and
a second pair of bit lines comprises a primary bit line and a complementary bit line coupled to respective access transistors of a second subset of cells of the column.

13. The apparatus of claim 12, wherein:
the first pre-charge circuit is coupled to the first pair of bit lines; and
the second pre-charge circuit is coupled to the second pair of bit lines.

14. The apparatus of claim 12 or 13, wherein the control circuit is to perform a write operation for the first subset of memory cells via the first pair of bit lines concurrent with performing a read operation for the second subset of memory cells via the second pair of bit lines.

15. The apparatus of any one of claims 12-14, wherein the control circuit is to perform a pre-charge for the first subset of memory cells via the first pair of bit lines concurrent with performing a read or write operation for the second subset of memory cells via the second pair of bit lines.
